# EUROPÄISCHE PATENTSCHRIFT

(11) **EP 3 155 701 B1**
(45) Veröffentlichungstag und Bekanntmachung des Hinweises auf die Patenterteilung: **01.01.2020**
(21) Anmeldenummer: 15730389.2
(22) Anmeldetag: 30.05.2015
(51) Int. Cl.: H05K 5/00

(54) **KUNSTSTOFFUMSPRITZTE LEITERBAHNSTRUKTUR SOWIE VERFAHREN ZUR HERSTELLUNG DER KUNSTOFFUMSPRITZEN LEITERBAHNSTRUKTUR**
PLASTIC INJECTION OVERMOULDED CONDUCTOR PATH STRUCTURE, AND METHOD FOR PRODUCING THE PLASTIC INJECTION OVERMOULDED CONDUCTOR PATH STRUCTURE
STRUCTURE À TRACÉ CONDUCTEUR À SURMOULAGE EN MATIÈRE PLASTIQUE ET PROCÉDÉ DE PRODUCTION DE LA STRUCTURE À TRACÉ CONDUCTEUR À SURMOULAGE EN MATIÈRE PLASTIQUE

(30) Priorität: 14.06.2014 DE 102014008853
(43) Veröffentlichungstag der Anmeldung: 19.04.2017
(73) Patentinhaber: Audi AG, 85045 Ingolstadt (DE)
(72) Erfinder: KISCHKAT, Ralf, 85080 Gaimersheim (DE)
(74) Vertreter: Eickmeyer, Dietmar
(86) Internationale Anmeldenummer: PCT/EP2015/001100
(87) Internationale Veröffentlichungsnummer: WO 2015/188919

(56) Entgegenhaltungen:
- DE-A1-102004 020 085
- DE-A1-102009 026 459
- DE-A1-102009 046 467
- DE-A1-102009 047 051

## Beschreibung

Die Erfindung betrifft eine kunststoffumspritzte Leiterbahnstruktur gemäß der im Oberbegriff des Patentanspruches 1 angegebenen Art sowie ein Verfahren zur Herstellung der kunststoffumspritzten Leiterbahnstruktur gemäß der im Oberbegriff des Patentanspruches 6 angegebenen Art.

Kunststoffumspritzte Leiterbahnstrukturen sind für große Stückzahlen kostenoptimale elektrische Verbindungselemente, wie sie beispielsweise in Getrieben im Fahrzeugbau eingesetzt werden. Neben der niedrigen Kosten ist ihr besonderer Vorteil, dass sie auch große elektrische Ströme tragen können und konstruktiv an die benötigen Leistungen und Geometrien einfach anpassbar sind. Gegenüber der Verbindungstechnologie "Kabel" fallen zwar höhere Werkzeugkosten an, dafür ist der Stückpreis deutlich geringer.

Eine gattungsgemäße kunststoffumspritzte Leiterbahnstruktur ist in der DE 10 2004 020 085 A1.

Entsprechende Verfahren zur Herstellung einer kunststoffumspritzten Leiterbahnstruktur sind aus dem Stand der Technik hinreichend bekannt und umfassen - wie z.B. der Offenbarung der DE 10 2009 026 459 A1 zu entnehmen ist, die nachfolgenden Verfahrensschritte:
- Stanzen/Schneiden der Leiterbahnen aus einem Metallblech, wobei Verbindungsstege an einzelnen Stellen der Leiterbahnen stehen gelassen werden, um ein Auseinanderfallen der Leiterbahnen zu verhindern;
- Anbringen von Vorumspritzungen: aus Kunststoff werden erste Gehäuseabschnitte erstellt, die die Leiterbahnen am Auseinanderfallen hindern sollen, sobald der nächste Arbeitsgang abgeschlossen ist. Das Leiterbahnpacket mit den Verbindungsstegen wird hierfür in ein Kunststoffspritzgußwerkzeug eingelegt und an den zu haltenden Stellen außerhalb der metallenen Verbindungsstege umspritzt;
- Enfernen der Verbindungsstege, z. B. durch Stanzen, Schneiden, Umbiegen;
- Anbringen einer Hauptumspritzung: aus Kunststoff werden an die ersten Gehäuseabschnitte angrenzende zweite Gehäuseabschnitte erstellt. Diese geben den Leiterbahnen mechanische Festigkeit und isolieren die Leiter gegenseitig (sie könnten sich ja berühren und Kurzschlüsse bilden) sowie gegen Umwelteinflüsse (z. B. gegen Metallspäne, die ebenfalls Kurzschlüsse bilden könnten).

Die DE 10 2009 046 467 A1 offenbart ein Leiterbahnstanzgitter mit einem Kernelement, einer daran angrenzenden kunststoffhaltigen Vorumspritzung, die zumindest teilweise von einer kunststoffhaltigen Hauptumspritzung umgeben ist, wobei die Vorumspritzung zumindest einen Abstützbereich für ein Werkzeug umfasst, der sich durch die Hauptumspritzung hindurch bis zur Oberfläche der Hauptumspritzung erstreckt. Eine Oberflächenkontur der Vorumspritzung ist geometrisch so ausgestaltet, dass ein Eindringen einer Flüssigkeit zwischen der Hauptumspritzung und der Vorumspritzung erschwert ist.

Die DE 10 2009 047 051 A1 offenbart ein Leiterbahnstanzgitter mit einem Kernelement das zum Leiten elektrischer Ströme ausgebildet ist, wobei das Kernelement zumindest einen mit mehreren Kunststoffschichten ummantelten ersten Bereich und zumindest einen zweiten Bereich, der der Kontaktierung einer Zusatzkomponente dient, aufweist. Es ist eine von zumindest einer Kunststoffschicht bedeckte und Klebstoff umfassende Zwischenschicht vorgesehen.

Da der Kunststoff unter hohem Druck und hohen Temperaturen gespritzt wird und beim Abkühlen sich das Material zusammenzieht, entstehen zwischen den Leiterbahnen und dem Kunststoff sowie zwischen dem Kunststoff der Vor- und Hauptumspritzungen Spalte. Durch diese Spalte gelangen Luft und Flüssigkeit. Der Spalt zwischen Vorund Hauptumspritzung bildet normalerweise einen Verbindungspfad zwischen den Leitern. Wenn Flüssigkeiten in den Spalt eindringen, kann dies bei Vorliegen entsprechender Umgebungsbedingungen, wie z.B. hohe Temperaturen, zur Bildung eines Mikroklima führen. Die Folge davon ist, dass die Flüssigkeiten u.U. "leitend werden" und sich dadurch Kurzschlüsse bilden. Eine andere Möglichkeit für Kurzschlüsse: Es bilden sich Reaktionsprodukte aus der Reaktion der Flüssigkeiten mit Luftbestandteilen, Kunststoffbestandteilen oder Leiterbahnmaterial.

Der Erfindung liegt die Aufgabe zugrunde, eine kunststoffumspritzte Leiterbahnstruktur gemäß der im Oberbegriff des Patentanspruches 1 angegebenen Art derart weiterzubilden, die Gefahr des Auftretens von Kurzschlüssen minimiert ist.

Diese Aufgabe wird durch die kennzeichnenden Merkmale des Patentanspruches 1 in Verbindung mit seinen Oberbegriffsmerkmalen gelöst.

Die Unteransprüche bilden vorteilhafte Weiterbildungen der Erfindung.

In bekannter Art und Weise sind bei der kunststoffumspritzten Leiterbahnstruktur die Leiterbahnen mit Ausnahme ihrer Anschlüsse vollständig von einem Gehäuse aus Kunststoff umschlossen. Das Gehäuse weist dabei zwei Gehäuseabschnitte auf, nämlich erste Gehäuseabschnitte, die in einem ersten Spritzgussvorgang - nachfolgend auch als Vorumspritzung bezeichnet - hergestellt wurden und über eine Kontaktfläche unmittelbar daran angrenzende zweite Gehäuseabschnitte, die in einem zweiten Spritzgussvorgang - nachfolgend auch als Hauptumspritzung bezeichnet - hergestellt wurden.

Erfindungsgemäß weist das Gehäuse im Bereich der Kontaktfläche zumindest eine Materialaussparung auf. Die Materialaussparung ist dabei hinsichtlich ihrer Form und Größe so dimensioniert, dass über die Materialaussparung ein Flüssigkeitsaustausch mit der Umgebung ermöglicht ist.

Durch die erfindungsgemäße Ausgestaltung ist nunmehr in vorteilhafter Weise sichergestellt, dass im Bereich der Kontaktfläche zwischen den beiden Gehäuseabschnitten durch die Materialaussparung große Mengen von Flüssigkeiten Ein-/Aus-/Durchtreten können, sodass die Bildung eines Mikroklimas vermieden wird, d.h. die Gefahr eines Kurzschlusses ist dadurch deutlich minimiert.

Vorzugsweise ist dabei die Materialaussparung durch eine in das Gehäuse von außen eingebrachte, in der Gehäuseoberfläche eine Eintrittsöffnung bildende Bohrung ausgebildet. Die Bohrung kann dabei durchgehend als auch als Sackloch bzw. Sackbohrung ausgeführt sein. Die Ausbildung der Materialaussparung in Form einer Bohrung erweist sich insbesondere im Hinblick auf die Fertigung von Vorteil, da diese kostengünstig herstellbar sind. Der oben verwendete Begriff "Bohrung" ist in diesem Kontext so zu verstehen, dass sämtliche von außen in das Gehäuse eingebrachte Materialausnehmung, z.B. auch in Form einer Öffnung oder Loches, mit umfasst sein sollen.

Gemäß einer Ausführungsform der Erfindung ist die bzw. sind die durch die Bohrung(en) in der Gehäuseoberflächen resultierenden Eintrittsöffnungen mittels eines Verschlussmittels, insbesondere in Form einer Vergussmasse, wieder geschlossen. Diese Ausführungsform erweist sich insbesondere dann von Vorteil, wenn die Gefahr besteht, dass eine Leiterbahn nicht mehr von einer ausreichend dicken Kunststoffschicht bedeckt ist. Hierdurch ist insbesondere die Gefahr eines Kurzschlusses durch eine Anlagerung von Fremdpartikeln deutlich reduziert.

In einer besonderen Ausprägeform kann die Materialaussparung auch den gesamten Raum zwischen den Vorumspritzungen einnehmen, so dass die kunststoffumspritzte Leiberbahnstruktur wie mehrfache Leiter mit Einzelisolierung und Stützung durch Vorumspritzugen aussieht.

Der Erfindung liegt weiterhin die Aufgabe zugrunde, ein Verfahren zur Herstellung der kunststoffumspritzten Leiterbahnstruktur anzugeben.

Diese Aufgabe wird durch die kennzeichnenden Merkmale des Patentanspruches 6 in Verbindung mit seinen Oberbegriffsmerkmalen gelöst.

Die Unteransprüche bilden vorteilhafte Weiterbildungen des Verfahrens.

In bekannter Art und Weise umfasst das Verfahren zur Herstellung einer kunststoffumspritzten Leiterbahnstruktur die Verfahrensschritte:
- Herstellen von Leiterbahnen aus einem Metallblech, wobei die einzelnen Leiterbahnen über metallische Verbindungsstege miteinander verbunden sind;
- Einlegen der über die Verbindungsstege miteinander verbunden Leiterbahnen in ein Kunststoffspritzgußwerkzeug und Anbringen einer Vorumspritzung aus einem Kunststoffmaterial, bei der zumindest zwei in Leiterbahnlängsrichtung betrachtet getrennt ausgebildete, die Leiterbahnen miteinander fixierende und beabstandet zu den Verbindungsstegen positionierte erste Gehäuseabschnitte hergestellt werden, wobei die Vorumspritzung ausschließlich auf die ersten Gehäuseabschnitte begrenzt wird, so dass zwischen zwei ersten Gehäuseabschnitten liegende Bereiche der Leiterbahnen ausgespart werden;
- Entfernen der Verbindungsstege;
- Einlegen der über die ersten Gehäuseabschnitte beabstandet zueinander fixierten Leiterbahnen in ein Kunststoffspritzgußwerkzeug und Anbringen einer Hauptumspritzung aus einem Kunststoffmaterial, bei der zweite Gehäuseabschnitte hergestellt werden, die über Kontaktflächen unmittelbar an die ersten Gehäuseabschnitte angrenzen und die die ausgesparten Bereiche der Leiterbahnen vollständig umschließen.

Erfindungsgemäß wird im Bereich der Kontaktfläche zwischen erstem und zweitem Gehäuseabschnitt eine Materialaussparung eingebracht.

Gemäß einer ersten Ausführungsform wird die Materialaussparung durch eine entsprechende Ausbildung des Kunststoffspritzwerkzeugs beim Anbringen der Hauptumspritzung eingebracht. Dies erweist sich als vorteilhaft, da für das Einbringen der Materialaussparung keine weiteren Fertigungsschritte erforderlich sind.

Gemäß einer anderen Ausführungsform wird die Materialaussparung nach Anbringen der Hauptumspritzung durch ein spanendes Fertigungsverfahren eingebracht.

Vorzugsweise erfolgt dies mittels Bohren, Stanzen, Laserschneiden oder Wasserstrahlschneiden.

Eine weitere vorteilhafte Ausführungsform des Verfahrens sieht vor, dass die durch die Materialaussparung in der Gehäuseoberfläche gebildeten Eintrittsöffnungen wieder verschlossen werden, insbesondere mittels vergießen mit einer Vergussmasse.

Weitere Vorteile, Merkmale und Anwendungsmöglichkeiten der vorliegenden Erfindung ergeben sich aus der nachfolgenden Beschreibung in Verbindung mit den in den Zeichnungen dargestellten Ausführungsbeispielen.

In der Beschreibung, in den Ansprüchen und in der Zeichnung werden die in der unten aufgeführten Liste der Bezugszeichen verwendeten Begriffe und zugeordneten Bezugszeichen verwendet.

In der Zeichnung bedeutet:
- Fig. 1: Leiterbahnen für die Herstellung für Herstellung einer erfindungsgemäßen kunststoffumspritzten Leiterbahnstruktur;
- Fig. 2: die Leiterbahnen aus Fig. 1 nach einem weiteren Verfahrensschritt;
- Fig. 3: die Leiterbahnen aus Fig. 2 nach einem weiteren Verfahrensschritt;
- Fig. 4: die Leiterbahnen aus Fig. 3 mit hervorgehobenen Konktaktflächen und
- Fig. 5: die erfindungsgemäße kunststoffumspritzte Leiterbahnstruktur.

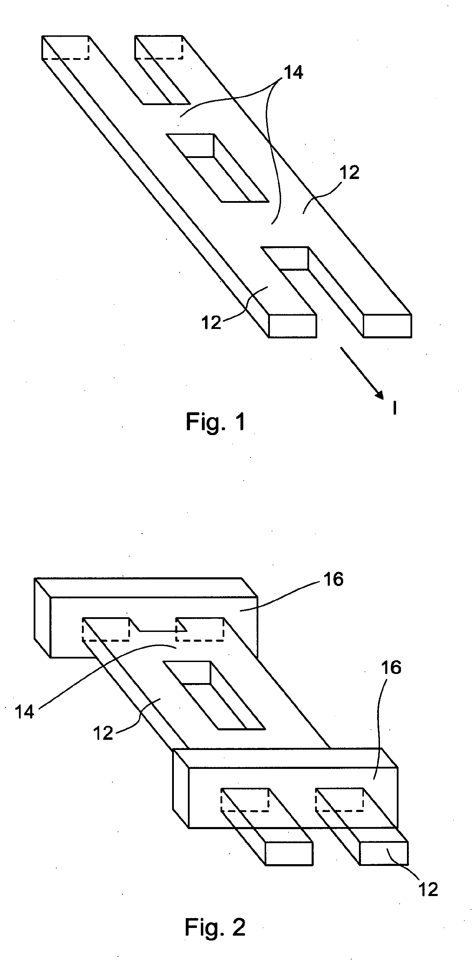

In Fig. 1 bis Fig. 5 sind die einzelnen Verfahrensschritte zur Herstellung einer insgesamt mit der Bezugsziffer 10 bezeichneten kunststoffumspritzten Leiterbahnstruktur dargestellt.

Ausgangspunktist - Fig. 1 zu entnehmen ist - ein die Leiterbahnen 12 bildendes gestanztes Metallblech. Die Leiterbahnen 12 sind hierbei noch über Verbindungsstege 14 miteinander verbunden, um ein Auseinanderfallen der Leiterbahnen 12 zu verhindern.

In Fig. 1 ist lediglich eine Lage der Leiterbahnen 12 dargestellt. Lediglich der Vollständigkeit halber wird darauf hingewiesen, dass in der herzustellenden Leiterbahnstruktur mehrere Lagen dieser Leiterbahnen über und/oder nebeneinander angeordnet sein können.

In einem nächsten Verfahrensschritt werden die Leiterbahnen aus Fig. 1 in ein Spritzgusswerkzeug eingelegt und es wird in einem ersten Spritzgussvorgang eine Vorumspritzung an die Leiterbahnen 12 angebracht. Durch die Vorumspritzung werden erste Gehäuseabschnitte 16 hergestellt, die ein Auseinanderfallen der Leiterbahnen 12 ohne Verbindungsstege 14 gewährleisten sollen. Vorliegend sind zwei in Leiterlängsrichtung 1 betrachtet voneinander getrennt ausgebildete erste Gehäuseabschnitte 16 dargestellt. Bei der Vorumspritzung werden die Verbindungsstege 14 ausgespart. Zudem ist die Vorumspritzung - wie Fig. 2 deutlich zu entnehmen ist - ausschließlich auf die hergestellten ersten Gehäuseabschnitte 16 begrenzt, d.h. die zwischen den ersten Gehäuseabschnitten 16 liegende Bereich der Leiterbahnen 12 werden nicht umspritzt.

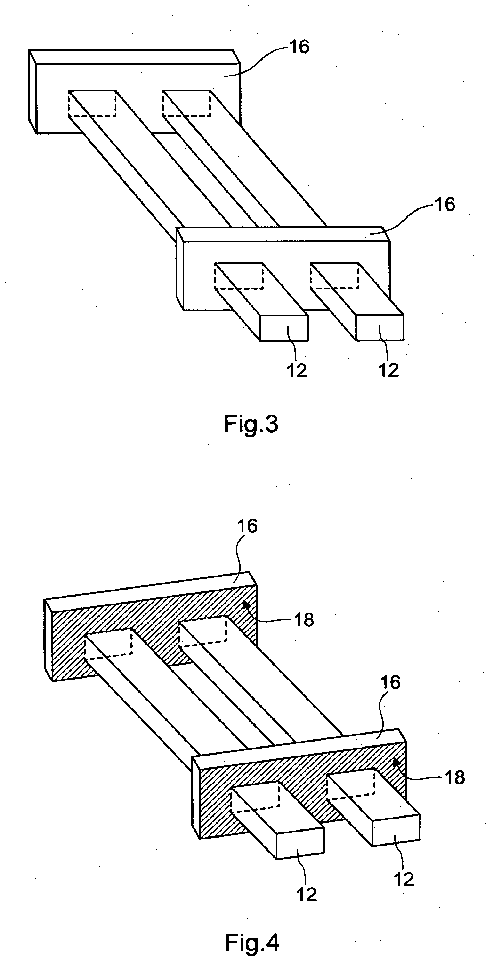

Im nachfolgenden Verfahrensschritt werden die Verbindungsstege 14 entfernt. Dies kann z.B. durch Stanzen, Schneiden oder Umbiegen erfolgen. Wie Fig. 3 zu entnehmen ist, sind die Leiterbahnen 12 durch die ersten Gehäuseabschnitten 16 definiert beabstandet zueinander positioniert.

Die zwischen den ersten Gehäuseabschnitten 16 liegenden, noch nicht umspritzten Bereiche der Leiterbahnen 12 werden in einem nachfolgenden Verfahrensschritt noch mit Kunststoff umspritzt.

Hierzu werden die über die ersten Gehäuseabschnitten 16 beabstandet zueinander fixierten Leiterbahnen 12 in ein Spritzgusswerkzeug eingelegt und es wird in einem zweiten Spitzgussvorgang zwischen den ersten Gehäuseabschnitten 16 eine Hauptumspritzung angebracht. Durch die Hauptumspritzung werden zweite Gehäuseabschnitte gebildet. Da die durch die Hauptumspritzung gebildeten zweiten Gehäuseabschnitten unmittelbar an die ersten Gehäuseabschnitten 16 angrenzen, weisen die ersten und zweiten Gehäuseabschnitten Kontaktflächen 18.

Diese Kontaktflächen 18 zwischen Vor- und Hauptumspritzung, die zu den Kurzschlüssen führen könnten, sind in Fig. 4 dargestellt.

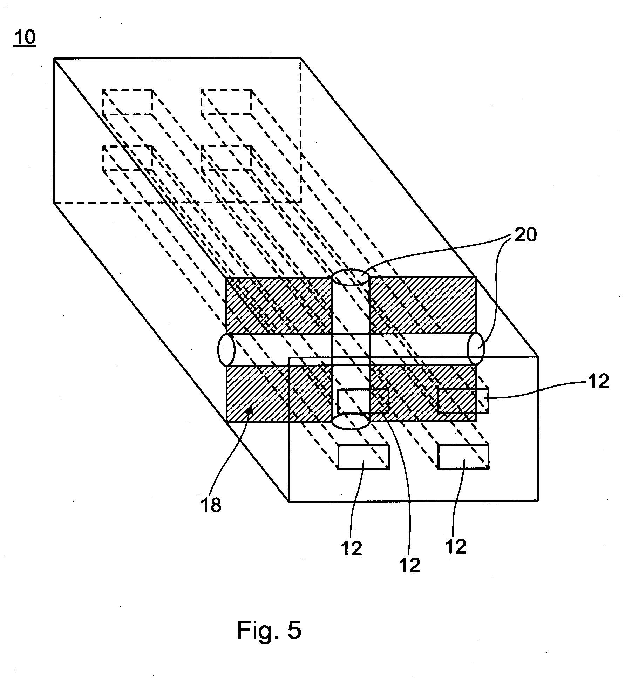

Fig. 5 zeigt die erfindungsgemäße kunststoffumspritzte Leiterbahnstruktur 10 nach Hauptumspritzung und Einbringen von Materialaussparungen 20 in der Kontaktfläche 18. Vorliegend sind die Materialaussparungen in Form von Bohrungen ausgebildet.

Durch die erfindungsgemäße Ausbildung ist nunmehr sichergestellt, dass im Bereich der Kontaktfläche 18 zwischen den beiden Gehäuseabschnitten durch die Bohrungen 20 große Mengen von Flüssigkeiten Ein-/Aus-/Durchtreten können, sodass die Bildung eines Mikroklimas vermieden wird und die Gefahr eines Kurzschlusses deutlich minimiert ist.

In einer nicht dargestellten Ausführungsform der Erfindung kann das Loch/die Öffnung in der Gehäuseoberfläche mit einer Masse verfüllt und damit abgedichtet werden. Dies kann z.B. vorteilhaft sein, wenn die Gefahr besteht, dass eine Leiterbahn nicht mehr von einer ausreichend dicken Kunststoffschicht umschlossen wird. Dies kann den Vorteil haben, z.B. die Gefahr von Kurzschlüssen durch Fremdpartikel zu reduzieren, die sich dort anlagern könnten und ebenfalls Kurzschlüsse herstellen könnten.

### Bezugszeichenliste

- 10: kunststoffumspritzte Leiterbahnstruktur
- 12: Leiterbahnen
- 14: Verbindungsstege
- 16: erster Gehäuseabschnitt
- 18: Kontaktfläche
- 20: Materialaussparung

- 1: Leiterlängsrichtung

## Patentansprüche

1. Kunststoffumspritzte Leiterbahnstruktur (10), bei der die Leiterbahnen (12) mit Ausnahme ihrer Anschlüsse vollständig von einem Gehäuse aus Kunststoff umschlossen sind, wobei das Gehäuse in einem ersten Spritzgussvorgang - Vorumspritzung - hergestellte erste Gehäuseabschnitte (16) und über eine Kontaktfläche unmittelbar daran angrenzende, in einem zweiten Spritzgussvorgang - Hauptumspritzung- hergestellte zweite Gehäuseabschnitte umfasst, **dadurch gekennzeichnet, dass** das Gehäuse im Bereich der Kontaktflächen mit zumindest einer in Form und Größe definiert ausgebildeten Materialaussparung (20) versehen ist.

2. Leiterbahnstruktur nach Anspruch 1, **dadurch gekennzeichnet, dass** die Materialaussparung (20) durch eine in das Gehäuse von außen eingebrachte, in der Gehäuseoberfläche zumindest eine Eintrittsöffnung bildende Bohrung ausgebildet ist.

3. Leiterbahnstruktur nach Anspruch 2, **dadurch gekennzeichnet, dass** die Bohrung als eine Durchtrittsbohrung oder als eine Sacklochbohrung ausgebildet ist.

4. Leiterbahnstruktur nach Anspruch 2 oder 3, **dadurch gekennzeichnet, dass** die Eintrittsöffnung(en) in der Gehäuseoberfläche mittels eines Verschlussmittels geschlossen ist(sind).

5. Leiterbahnstruktur nach Anspruch 4, **dadurch gekennzeichnet, dass** das Verschlussmittel in Form einer Vergußmasse ausgebildet ist.

6. Verfahren zur Herstellung einer von einem Gehäuse aus einem Kunststoffmaterial umschlossenen Leiterbahnstruktur (10), umfassend die Verfahrensschritte:
- Herstellen von Leiterbahnen (12) aus einem Metallblech, wobei die einzelnen Leiterbahnen (12) über metallische Verbindungstege (14) miteinander verbunden sind;
- Einlegen der über die Verbindungsstege (14) miteinander verbundenen Leiterbahnen (12) in ein Kunststoffspritzgusswerkzeug und Anbringen einer Vorumspritzung aus einem Kunststoffmaterial, bei der zumindest zwei in Leiterbahnlängsrichtung (l) betrachtet getrennt ausgebildete, die Leiterbahnen (12) miteinander fixierende und beabstandet zu den Verbindungsstegen positionierte erste Gehäuseabschnitte (16) hergestellt werden, wobei die Vorumspritzung ausschließlich auf die ersten Gehäuseabschnitte (16) begrenzt wird, sodass zwischen zwei ersten Gehäuseabschnitten (16) liegende Bereiche der Leiterbahnen (12) ausgespart werden;
- Entfernen der Verbindungsstege (14);
- Einlegen der über die ersten Gehäuseabschnitte (16) beabstandet zueinander fixierten Leiterbahnen (10) in ein Kunststoffspritzgusswerkzeug und Anbringen einer Hauptumspritzung aus einem Kunststoffmaterial, bei der zweite Gehäuseabschnitte hergestellt werden, die über Kontaktflächen (18) unmittelbar an die ersten Gehäuseabschnitte (16) angrenzen und die die ausgesparten Bereiche der Leiterbahnen (12) vollständig umschließen
**dadurch gekennzeichnet, dass** im Bereich der Kontaktfläche (18) zwischen ersten und zweite Gehäuseabschnitt eine Materialaussparung (20) eingebracht wird.

7. Verfahren nach Anspruch 6, **dadurch gekennzeichnet, dass** die Materialaussparung (20) durch eine entsprechende Ausbildung des Kunststoffspritzgusswerkzeugs beim Anbringen der Hauptumspritzung eingebracht wird.

8. Verfahren nach Anspruch 6, **dadurch gekennzeichnet, dass** die Materialaussparung (20) nach Anbringen der Hauptumspritzung durch ein spanendes Fertigungsverfahren eingebracht wird.

9. Verfahren nach Anspruch 8, **dadurch gekennzeichnet, dass** die Materialaussparung (20) mittels Bohren, Stanzen, Laserschneiden oder Wasserstrahlschneiden eingebracht wird.

10. Verfahren nach einem der vorgenannten Ansprüche, **dadurch gekennzeichnet, dass** eine durch die Materialaussparung in der Gehäuseoberfläche gebildeten Eintrittsöffnung wieder verschlossen wird.

11. Verfahren nach Anspruch 10, **dadurch gekennzeichnet, dass** die Eintrittsöffnung(en) mittels vergießen mit einer Vergussmasse verschlossen wird (werden).

## Claims

1. Plastic injection overmoulded conductor path structure (10), in which the conductor paths (12) with the exception of their connections are entirely enclosed by a housing made of plastic, wherein the housing comprises first housing portions (16) manufactured in a first injection moulding procedure - pre-overmoulding - and second housing portions, adjoining directly thereon via a contact surface, manufactured in a second injection moulding procedure - main overmoulding -, **characterised in that** the housing in the region of the contact surfaces is equipped with at least one material gap (20) formed defined in form and size.

2. Conductor path structure according to claim 1, **characterised in that** the material recess (20) is formed by a bore introduced from the outside into the housing, forming at least one entry opening in the housing surface.

3. Conductor path structure according to claim 2, **characterised in that** the bore is designed as a through-bore or as a blind bore.

4. Conductor path according to claim 2 or 3, **characterised in that** the entry opening(s) in the housing surface is (are) closed by means of a closing means.

5. Conductor path according to claim 4, **characterised in that** the closing means is designed in the form of a casting compound.

6. Method for producing a conductor path structure (10) enclosed by a housing made of a plastic material, comprising the method steps:
- producing conductor paths (12) from a metal sheet, wherein the individual conductor paths (12) are connected with one another via metallic connection webs (14);
- laying the conductor paths (12) connected with one another via the connection webs (14) into a plastic injection moulding tool and applying a pre-overmoulding made of a plastic material, in the case of which at least two housing portions (16) are produced, which are formed separated viewed in conductor path longitudinal direction (1), which fix the conductor paths (12) with one another and which are positioned spaced from the connection webs, wherein the pre-overmoulding is limited exclusively to the first housing portions (16), such that portions of the conductor paths (12) situated between two first housing portions (16) are left out;
- removing the connection webs (14);
- laying the conductor paths (10), fixed by means of the first housing portions (16) spaced from one another, in a plastic injection moulding tool and applying a main-overmoulding made of a plastic material, in which the second housing portions are produced which adjoin directly on the first housing portions (16) via contact surfaces (18) and which entirely enclose the left-out portions of the conductor paths (12)
**characterised in that** in the region of the contact surface (18) between first and second housing portion a material gap (20) is introduced.

7. Method according to claim 6, **characterised in that** the material gap (20) is introduced by means of an appropriate designing of the plastic injection moulding tool when applying the main-overmoulding.

8. Method according to claim 6, **characterised in that** the material gap (20) is introduced after applying the main-overmoulding by means of a machining manufacturing process.

9. Method according to claim 8, **characterised in that** the material gap (20) is introduced by means of drilling, punching, laser cutting or water jet cutting.

10. Method according to any of the preceding claims, **characterised in that** an entry opening formed by the material gap in the housing surface is closed again.

11. Method according to claim 10, **characterised in that** the entry opening(s) is (are) closed by means of casting with a casting compound.

## Revendications

1. Structure à tracé conducteur (10) à surmoulage en matière plastique, dans laquelle les tracés conducteurs (12) sont entourés, à l'exception de leurs raccords, complètement par un boîtier en matière plastique, dans laquelle le boîtier comprend des premières sections de boîtier (16) fabriquées lors d'une première opération de moulage par injection - surmoulage préalable - et des secondes sections de boîtier, adjacentes directement à celles-ci par l'intermédiaire d'une surface de contact, fabriquées lors d'une seconde opération de moulage par injection - surmoulage principal -, **caractérisée en ce que** le boîtier est pourvu, dans la zone des surfaces de contact, d'au moins un évidement de matériau (20) réalisé avec une forme et une taille définies.

2. Structure à tracé conducteur selon la revendication 1, **caractérisée en ce que** l'évidement de matériau (20) est réalisé par un perçage, pratiqué dans le boîtier de l'extérieur, formant dans la surface de boîtier au moins une ouverture d'entrée.

3. Structure à tracé conducteur selon la revendication 2, **caractérisée en ce que** le perçage est réalisé comme un perçage de passage ou comme un perçage borgne.

4. Structure à tracé conducteur selon la revendication 2 ou 3, **caractérisée en ce que** l'ouverture/les ouvertures est/sont fermée(s) dans la surface de boîtier au moyen d'un moyen de fermeture.

5. Structure à tracé conducteur selon la revendication 4, **caractérisée en ce que** le moyen de fermeture est réalisé sous la forme d'une masse de coulée.

6. Procédé de fabrication d'une structure à tracé conducteur (10) entourée par un boîtier en un matériau plastique, comprenant les étapes de procédé suivantes :
- la fabrication de tracés conducteurs (12) en une tôle métallique, dans lequel les tracés conducteurs (12) individuels sont reliés par l'intermédiaire de nervures de liaison (14) métalliques les uns aux autres ;
- l'insertion des tracés conducteurs (12) reliés les uns aux autres par l'intermédiaire des nervures de liaison (14) dans un outil de moulage par injection en matière plastique et le montage d'un surmoulage préalable en un matériau plastique, dans lequel au moins deux premières sections de boîtier (16) réalisées séparément, dans une vue dans le sens longitudinal du tracé conducteur (1), fixant les uns aux autres les tracés conducteurs (12) et positionnées à distance des nervures de liaison sont fabriquées, dans lequel le surmoulage préalable est limité exclusivement aux premières sections de boîtier (16) de sorte que des zones, se trouvant entre deux premières sections de boîtier (16), des tracés conducteurs (12) soient évitées ;
- le retrait des nervures de liaison (14) ;
- l'insertion des tracés conducteurs (10) fixés à distance les uns des autres par l'intermédiaire des premières sections de boîtier (16) dans un outil de moulage par injection en matière plastique et le montage d'un surmoulage principal en un matériau plastique, dans lequel des secondes sections de boîtier sont fabriquées, lesquelles sont adjacentes par l'intermédiaire de surfaces de contact (18) directement aux premières sections de boîtier (16) et lesquelles entourent complètement les zones évitées des tracés conducteurs (12),
**caractérisé en ce qu'**un évidement de matériau (20) est pratiqué dans la zone de la surface de contact (18) entre la première et la seconde section de boîtier.

7. Procédé selon la revendication 6, **caractérisé en ce que** l'évidement de matériau (20) est pratiqué par une réalisation correspondante de l'outil de moulage par injection en matière plastique lors du montage du surmoulage principal.

8. Procédé selon la revendication 6, **caractérisé en ce que** l'évidement de matériau (20) est pratiqué après le montage du surmoulage principal par un procédé de fabrication par enlèvement de copeaux.

9. Procédé selon la revendication 8, **caractérisé en ce que** l'évidement de matériau (20) est pratiqué par perçage, estampage, coupe au laser ou coupe à jet d'eau.

10. Procédé selon l'une quelconque des revendications précédentes, **caractérisé en ce qu'**une ouverture d'entrée formée par l'évidement de matériau dans la surface de boîtier est refermée à nouveau.

11. Procédé selon la revendication 10, **caractérisé en ce que** l'ouverture/les ouvertures d'entrée est/sont fermée(s) par coulage avec une masse de coulée.
